Europäisches Patentamt

European Patent Office

Office européen des brevets

(19)

(11) Publication number: **0 074 806**
A1

## (12) EUROPEAN PATENT APPLICATION

(21) Application number: **82304752.7**

(22) Date of filing: **09.09.82**

(51) Int. Cl.³: **G 01 R 31/11**

(30) Priority: **10.09.81 ZA 816279**

(43) Date of publication of application:
**23.03.83 Bulletin 83/12**

(84) Designated Contracting States:
**BE DE FR GB IT NL**

(71) Applicant: **PATENTED DEVICES (PROPRIETARY) LIMITED**
**27 Heronmere Road Reuven**
**Johannesburg Transvaal(ZA)**

(72) Inventor: **Jenkinson, Christopher Graham**
**71 Worcester Road**
**Parkwood Johannesburg Transvaal(ZA)**

(74) Representative: **Parker, Jeffrey et al,**
**Frank B. Dehn & Co. Imperial House 15-19 Kingsway**
**London, WC2B 6UZ(GB)**

(54) **Cable testing.**

(57) An echo pulse equipment automatically compensates for the length of test leads by applying test pulses to the test leads before they are connected to a cable system to be tested. An appearance of a marker or the firing of a test pulse transmitter 10 is adjusted until the marker and the return of an echo pulse coincides. The adjustment is carried out by using any early returning echo pulses at a Schmitt trigger 18 to be counted by a counter 22 and cause adjustment of the delay of a delay circuit 26. The transmitter 10 is fired early at first and its delay reduced until the marker and echo pulses coincide.

EP 0 074 806 A1

Croydon Printing Company Ltd.

"Cable Testing"

The invention more particularly, although not exclusively, relates to locating faults in electrical cables by pulse echo techniques.   A pulse or train of pulses is transmitted from one end of a cable and echo pulses are generated by any impedance irregularities, usually faults, intermediate the length of the cable and returned to the one end.   The time taken between transmission of each pulse and the reception of a corresponding echo pulse is used to determine the distance of the fault from the one end.   Such techniques are known and used to locate the position of faults with precision.   In fact it is critical that such determinations are accurate otherwise when fault detecting in cables which are difficult to access, say underwater or underground cables, a great deal of effort is wasted. In this respect a measured error of only a few metres may be very detrimental.

In practice the test equipment usually comprises various electronic modules and a display or counter for monitoring pulse traces or time periods between pulses.   The equipment must be electrically connected to one end of a cable to be tested.

One particular problem arises as the one end of the cable may not be readily accessible or it may not be possible to position the test equipment immediately adjacent the one end of the cable. Usually test leads are therefore provided to connect between the test equipment and the one end of the cable. Such test leads may be a few or several metres long so that the pulses and echo pulses must travel the several metres of the test leads as well as to the fault and back in the cable. The time taken for the pulses to travel along the test leads makes the testing equipment give a false location of the fault.

It is known to calibrate the test equipment non-automatically for the test lead length by manual manipulation of marker indicators or to measure the test cable length used and make a substraction after a fault is located to allow for the length of the test leads but such procedures are laborious and usually require skilled operation of the test equipment.

It is an object of the invention to provide a cable test method and apparatus to locate impedance irregularities in the cable which can where required be used to compensate for the length of test leads.

According to one aspect of the invention there is provided a method of locating an impedance irregularity in a cable by pulse echo techniques which comprises applying test pulses to one end of a cable system to be tested, monitoring over time periods the return of respective echo pulses from the impedance irregularity in time relationship to the instances of application of the test pulses, and adjusting the beginning of the monitoring periods relative to the instances of application of the test pulses to provide coincidence between the return of echo pulses and the beginning of the monitoring periods so that the adjustment represents the distance of the impedance irregularity from the end of the cable system.

The method may include adjusting the instances of application of the test pulses relative to the beginning of the monitoring period in equal increments.

The method may include applying the test pulses to a test lead in which case the adjustment represents the length of the test lead.

The method may include applying a predetermined adjustment representing a predetermined length of a cable before carrying out the method in which case the adjustment made during the method represents the distance of an impedance irregularity beyond the predetermined length.

According to another aspect of the invention there is provided a test equipment for locating an impedance irregularity in a cable system by echo techniques comprising means to apply test pulses to one end of the cable system, means for monitoring over time periods the return of respective echo pulses in time relationship to the instances of application of the test pulses, and means for adjusting the beginning of the monitoring periods relative to the instances of application of the test pulses until the beginning of the monitoring periods and the return of the echo pulses coincide in which the adjustment that is made represents the distance of the impedance irregularity from the end of the cable system.

The test equipment may comprise a test pulse signal generator, circuit means arranged to produce firing signals for the signal generator and to provide corresponding switching signals extending for a time period and which is significantly less than the periods of time between consecutive firing pulses, switching circuit arranged to be switched ON by the switching signals and arranged to receive the echo pulses, means for receiving the echo pulses from the switching means and for developing an output signal corresponding to the number of echo pulses received, and a delay circuit arranged to receive the output signal and to provide a relative time period between the firing signals and the beginning of the switching signal corresponding to the output signal.

The delay circuit may be arranged to delay the beginning of the switching signals relative to the firing signals.

The means for receiving the echo pulses may comprise a counter and a digital to analogue convertor such that the output signal corresponds to the number of echo pulses received by the counter.

The test equipment may include means for applying a predetermined adjustment to the adjusting means representing a predetermined length of cable such that further adjustments represent the distance of an impedance irregularity beyond that predetermined length.  Such predetermined length can conveniently be the length of the test leads for example.

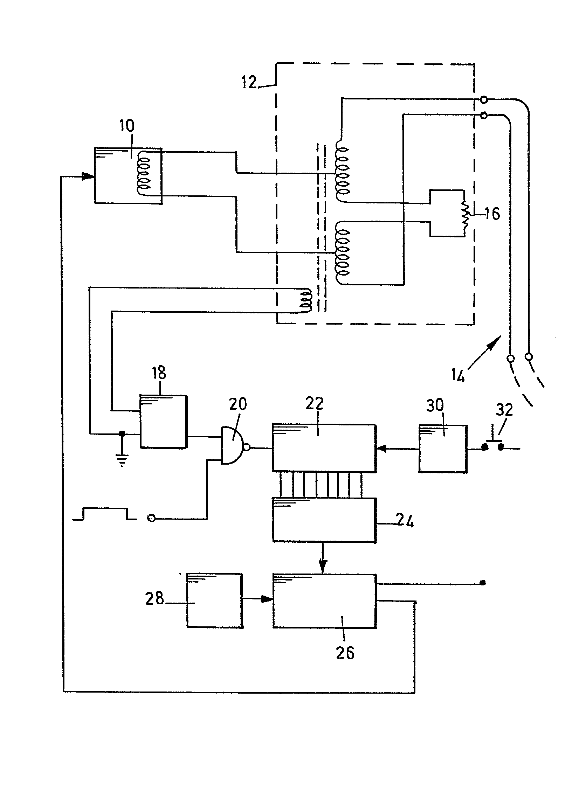

A test equipment and its method of use according to the invention will now be described by way of example with reference to the accompanying drawing which shows a schematic circuit of part of the equipment.

The equipment generally includes a pulse transmitter, a calibrated cathode ray display and various electronic control circuits.   In use, test pulses are generated and applied via test leads to one end of a cable to be tested.   An echo pulse, corresponding to each pulse applied to the cable, is produced by any impedance irregularity including faults in the cable and is received by the test equipment. The time taken between application of the test pulse and receipt of the echo pulse is indicative of the distance of a fault along the cable.   Such general equipment is already known.

The normal application of the test pulse to the cable system under test is indicated by a marker on the cathode ray tube.   The marker appears as a point or step, as desired, on a trace set and normally coincident with the firing of the transmitter and a similar interruption or shape in the trace appears on the screen corresponding to the receipt of an echo pulse.   This distance across the cathode ray tube between the marker and the start of the echo pulse represents the travel time of the pulse along the cable and the return of an echo pulse from a fault.   Conveniently, the cathode ray tube may have a calibrated scale of distance so the distance can be read directly on the cathode ray tube.   This distance may be alternatively provided by manually moving the marker point between its original position to the beginning of the echo pulse and providing a dial or similar arrangement which monitors that movement to provide a read-out of the distance indicated on the cathode ray tube which distance includes the length of the test leads.

Referring to the drawing, a transmitter 10 is provided for generating pulses to be applied to a test cable via a transformer network 12 and test leads 14.   A matching resistor 16 is provided in a measuring network so that normally no echo pulse is generated by the connection of the test leads to the equipment.

In this embodiment any echo pulses which are generated are supplied to a Schmitt trigger 18 which converts the echo pulse into a square shaped pulse. The output of the trigger 18 is supplied together with a marker waveform via an AND-gate 20 to a digital counter 22. The output of the counter 22 is supplied via a digital-to-analogue convertor 24 to a delay circuit 26 between a transmitter firing circuit 28 and the transmitter 10. The counter 22 is controlled by a circuit 30 which includes a reset-button 32.

The output impedance of the test equipment is arranged to be equal to or greater than the characteristic impedance of the test leads. In order to calibrate the equipment automatically to compensate for the length of the test leads the equipment is connected to the test leads that are to be used in the particular cable testing procedure. Pulses are then applied to the test leads and the echo from the open-circuited ends of the leads are received by the trigger 18. The echo pulses are ANDED to the marker waveform shown in the drawing. The marker waveform is a repetitive squarewave having a time period significantly less than time periods between test pulses which is so arranged as to be logical 1 until the marker has appeared on the screen. As long as the pulse from trigger 18 occurs prior to the marker waveform going to logical 0, it will be passed by the AND-gate 20 causing counter 22 to increment. The output of the convertor 24, controls the delay unit 26 to correspondingly decrease the delay of application of firing pulses to the transmitter 10. In this way, the marker on the screen will ultimately coincide with the time taken for the pulse to travel along and return from the ends of the test leads.

In other words, the firing of the transmitter 10 is at first fired too early and incrementally the delay in firing is decreased until the coincidence occurs. The transmitter 10 is fired before the marker appears on the screen initially and a time delay is incrementally decreased automatically until the marker and the start of the echo pulses occur simultaneously. The marker is therefore now set to start its timing so as to compensate for the length of the test leads.

If the equipment is now coupled via the test leads to a cable to be tested, distance measurements appearing on the cathode ray screen represent distances of faults along the cable. In fact, the transmitter fires before the marker appears by a time period corresponding to the length of the test leads. This means the time required for the test pulse and any corresponding echo pulse to travel the length of the leads does not form part of the timed period. Thus, the distance indicated on the cathode ray screen now is a true indication of the fault location relative to the start of the cable.

It will be noted that whereas compensation is provided in the described arrangement by adjustments to alter the advancement of the firing of the transmitter relative to the marker, the same circuit can be readily adapted instead to adjust delay the appearance of the marker until coincidence occurs. The delay required is determined by the circuit as generally described and that delay is then applied to delay the marker relative to the firing of the transmitter. In such a case, the delay circuit 26 is arranged to increase the delay of the marker incrementally until coincidence occurs between the marker and the echo pulses.

The equipment is preferably provided with an indicating device to show that the delay has been properly set. This is required in most equipment because the extent of the delay that can be provided is limited in practice.

A more general application of the invention can be provided using the equipment generally as described and shown in the drawing. In a general application the equipment is set up with the marker being generated to coincide with the firing of the transmitter 10. The equipment is then adjusted automatically, as described above until there is coincidence between the marker and the echo pulses. That is, the counter 22 counts up the echo pulses incrementally as they are received and provides via the converter 24 either an advance of the application of firing pulses relative to the marker or delay of the marker relative to the firing of the transmitter 10 as preferred. When the advance or the delay as the case may be is sufficient to provide coincidence between the marker and the echo pulses the counter 22 receives no further echo pulses because the AND-gate 20 remains closed to echo pulses and stops the count.

The count required by the counter 22 to reach this condition represents the adjustment which has been made to provide the coincidence of the marker and the echo pulses and corresponds to the distance of the fault or other impedance irregularity along the cable. Thus, by inspecting the count in the counter the distance is provided by calculation taking into account the physical properties of the particular cable; the count itself is of course a measure of the time of travel of pulses along the cable.

This general application therefore provides an automatic locating technique in which the distance of an impedance irregularity is determined by the amount of adjustment that is made to bring the marker and echo pulses into coincidence.

It will be noted that the delay represented in the counter 22 or convertor 26 may be useful in other procedures of cable testing. For example, when it is required to "impedance match" a cable it will be preferable to avoid the impedance characteristics of the test leads or possibly the first several metres of the cable itself. This may also be useful when it is required to "look at" a cable beyond a predetermined point. That point is selected by inputting into the counter 22 a count which represents or is equivalent to a predetermined distance along the cable.   If the circuit is allowed to make automatic adjustments thereafter the additional count represents a distance of another fault, say, beyond the predetermined distance.   Alternatively, if the counter 22 is locked, the characteristics of the cable can be inspected which lie immediately beyond the predetermined distance.   Further, for example, where test pulses are used for impedance matching the characteristics of the test leads or the first few or more metres of the cable can be ignored by using the time delay equal or somewhat greater than the time period represented in the counter 22 or convertor 26 without having to measure the actual length of the test leads.

In practical applications the firing of the transmitter is arranged to be adjusted to provide coincidence required to compensate for the length of the test leads, as compared top a common timing circuit in the equipment.   Thereafter the marker is advanced with respect to the common timing circuit to provide adjustment required to measure a distance of an impedance irregularity from the end of the cable system under test.

The test equipment in a practical application will receive more than one echo which may be caused by cable junctions for example and not necessarily faults or adverse impedance irregularities.   The test equipment is preferably provided with discriminating circuits to isolate various types of echo pulses from one another so that the coincidence described can be arranged in respect of different selective types of echo pulses.

CLAIMS

1.

A method of locating an impedance irregularity in a cable by pulse echo techniques which comprises applying test pulses to one end of a cable system to be tested, monitoring over time periods the return of respective echo pulses from the impedance irregularity in time relationship to the instances of application of the test pulses, and adjusting the beginning of the monitoring periods relative to the instances of application of the test pulses to provide coincidance between the return of echo pulses and the beginning of the monitoring periods so that the adjustment represents the distance of the impedance irregularity from the end of the cable system.

2.

A method according to claim 1 including adjusting the instances of application of the test pulses relative to the beginning of the monitoring period in equal increments.

3.

A method according to claim 1 or 2, in which the cable system comprises a test lead so that the adjustment represents the length of the test lead.

4.

A method according to any one of claims 1 to 3, including applying a predetermined adjustment representing a predetermined length of a cable before carrying out the method in which case the adjustment made during the method represents the distance of an impedance irregularity beyond the predetermined length.

5.

A test equipment for locating an impedance irregularity in a cable system by echo techniques comprising means to apply test pulses to one end of the cable system, means for monitoring over time periods the return of respective echo pulses in time relationship to the instances of application of the test pulses, and means for adjusting the beginning of the monitoring periods relative to the instances of application of the test pulses until the beginning of the monitoring periods and the return of the echo pulses coincide, in which the adjustment that is made represents the distance of the impedance irregularity from the end of the cable system.

6.

A test equipment according to claim 5, comprising a test pulse signal generator, circuit means arranged to produce firing signals for the signal generator and to provide corresponding switching signals extending for a time period and which is significantly less than the periods of time between consecutive firing pulses, switching circuit arranged to be switched ON by the switching signals and arranged to receive the echo pulses, means for receiving the echo pulses from the switching means and for developing an output signal corresponding to the number of echo pulses received, and a delay circuit arranged to receive the output signal and to provide a relative time period between the firing signals and the beginning of the switching signal corresponding to the output signal.

7.

A test equipment according to claim 6 in which the delay circuit is arranged to delay the beginning of the switching signals relative to the firing signals.

8.

A test equipment according to claim 6 or 7, in which the means for receiving the echo pulses comprises a counter and a digital to analogue convertor such that the output signal corresponds to the number of echo pulses received by the counter.

9.

A test equipment according to any one of claims 5 to 8, including means for applying a predetermined adjustment to the adjusting means representing a predetermined length of cable such that further adjustments represent the distance of an impedance irregularity beyond that predetermined length.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| | --- | | G 01 R 31/11 |
| A | DE-A-2 318 424 (H.C.KOSMEIER) *Pages 2-3; page 5, last paragraph to page 7, first paragraph; figure 1-2* | 1-5 | |
| | --- | | |
| A | DE-A-2 142 490 (SIEMENS) *Page 1, first paragraph; page 2, second paragraph to page 3, third paragraph* | 1,4,5, 9 | |
| | ----- | | |

TECHNICAL FIELDS SEARCHED (Int. Cl. ³)

G 01 R 31/11
G 01 S 13/16

The present search report has been drawn up for all claims

| Place of search THE HAGUE | Date of completion of the search 16-12-1982 | Examiner KUSCHBERT D.E. |
|---|---|---|